# EUROPÄISCHE PATENTSCHRIFT

(11) **EP 0 600 316 B1**
(45) Veröffentlichungstag und Bekanntmachung des Hinweises auf die Patenterteilung: **22.01.1997**
(21) Anmeldenummer: 93118598.7
(22) Anmeldetag: 18.11.1993
(51) Int. Cl.: H05K 13/02

(54) **Vorrichtung zum Zuführen von SMD-Bauteilen zu einem Bestückautomaten**
Apparatus for feeding SMD components to a mounting machine
Appareil d'alimentation en composants pour montage en surface vers une machine automatique de montage

(30) Priorität: 26.11.1992 DE 9216115 U
(43) Veröffentlichungstag der Anmeldung: 08.06.1994
(73) Patentinhaber: SIEMENS AKTIENGESELLSCHAFT, 80333 München (DE)
(72) Erfinder: Schulze-Kahleyss, Rainer, D-91341 Röttenbach (DE); Hierl, Robert, D-92272 Freudenberg (DE)

(56) Entgegenhaltungen:
- EP-A- 0 301 691
- GB-A- 2 244 482
- US-A- 5 116 185

## Beschreibung

Die Erfindung bezieht sich auf eine Vorrichtung zum Zuführen von SMD-Bauteilen, insbesondere von Halbleiter-Chips (IC's), zu einem Bestückautomaten zum Bestücken von Leiterplatten mit den Bauteilen mit mindestens einer auf einem Linearförderer angeordneten Zuführschiene, in welcher die Bauteile zu einem Abholplatz transportiert werden.

Empfindliche elektronische Bauteile, wie insbesondere Halbleiter-Chips mit integrierten Schaltungen (IC's), werden häufig in Stangenmagazinen angeliefert. Aus den Magazinen müssen sie zwecks bestimmungsgemäßer Verwendung zur Bestückung von Leiterplatten an die Aufnahmestelle eines Montage- bzw. Bestückkopfes am Bestückautomaten transportiert werden. Herkömmliche Bestückautomaten haben üblicherweise sogenannte Linearförderer mit entsprechenden Zuführschienen, in denen die Bauteile zum Abholplatz transportiert werden. Das Stangenmagazin aus Kunststoff wird dazu in Schrägstellung bzw. mit einer Abbiegung an die Zuführschiene angekoppelt.

In der Praxis ist die Ankoppelstelle zwischen dem Kunststoffmagazin und der Zuführschiene ein wesentlicher Schwachpunkt: Meist werden die IC-Magazine in einer kurzen Muffe aus Blech gehalten, die durch Verbiegen den jeweils vorliegenden Maßen angepaßt wird. Wegen der unterschiedlichen Magazinabmessungen der verschiedenen Hersteller ergibt sich aber durchweg eine undefinierbare Fixierung des Stangenmagazines, wodurch es zu Störungen bei der Bauteilezuführung kommen kann.

Aufgabe der Erfindung ist es daher, eine verbesserte Vorrichtung für die Zuführung von Bauteilen zu einem Bestückautomaten zu schaffen.

Die Aufgabe ist erfindungsgemäß dadurch gelöst, daß die Zuführschiene in ihrer Länge durchgehend über den gesamten Zuführbereich ausgebildet ist und nur im vorderen Bereich auf dem Linearförderer aufsitzt und daß die Zuführschiene an ihrem rückseitigen Ende einen Trichter zum Einfüllen der Bauteile aufweist.

Mit der neuen Vorrichtung ergeben sich für eine praxisgerechte Bestückung im laufenden Fertigungsbetrieb erhebliche Vorteile: Insbesondere ist die bisherige Schwachstelle zwischen Zuführschiene und Stangenmagazin beseitigt. Dadurch, daß vorteilhafterweise die Zuführschiene in dem vor dem Linearförderer liegenden Bereich nach oben gekrümmt ausgebildet ist, lassen sich über den Trichter die Bauteile einfüllen, von wo sie vorteilhafterweise durch ihr Eigengewicht zur Förderstelle rutschen.

Bei Realisierung der Erfindung bilden wie bisher mehrere Zuführschienen nebeneinander ein Zuführsystem für unterschiedlich ausgebildete Bauelemente. Dabei können aber nunmehr die Einfülltrichter vorzugsweise jeweils versetzt übereinander bzw. nebeneinander angeordnet sein.

Besondere Weiterbildungen und Ausgestaltungen der Erfindung sind in den Unteransprüchen angegeben.

Weitere Einzelheiten und Vorteile der Erfindung ergeben sich aus der nachfolgenden Figurenbeschreibung eines Ausführungsbeispiels. Es zeigen
- FIG. 1: eine teilweise geschnittene Seitenansicht einer Vorrichtung des Standes der Technik,
- FIG. 2: eine entsprechende Ansicht einer gegenüber FIG. 1 verbesserten Vorrichtung und
- FIG. 3: in fünf Teilfiguren drei unterschiedliche Ausbildungen von Trichteranordnungen im Querschnitt.

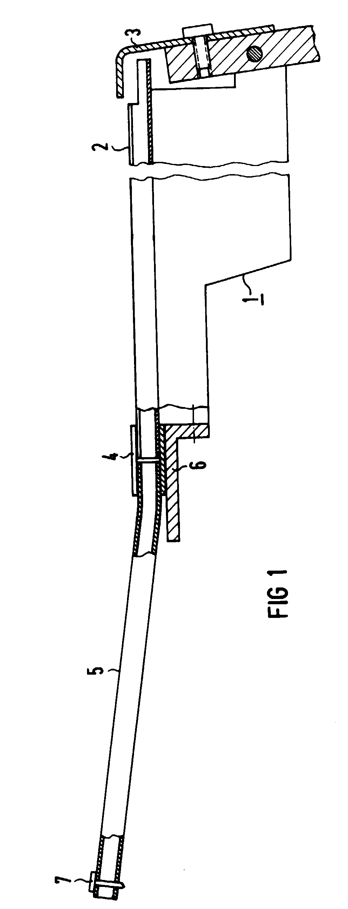

In FIG. 1 ist mit 1 ein Linearförderer für Bauteile angedeutet, welcher Teil eines Bestückautomaten zum Bestücken von Leiterplatten mit SMD-Bauteilen ist. Mit dem Linearförderer 1 werden insbesondere IC's, die in Kunststoffmagazinen angeliefert werden, von einer Empfangsstation zum eigentlichen Abholplatz transportiert. Dazu befindet sich auf dem Linearförderer eine Zuführschiene 2. Ein Niederhalter 3 am Linearförderer 1 dient zum Festhalten des letzten Bauteiles in geeigneter Position. An die Zuführschiene 2 können mittels einer Blechmuffe 4 Stangenmagazine 5 angekoppelt werden, wobei als Unterlage an der Ankoppelstelle üblicherweise ein Lagerbock 6 dient.

Es ist ersichtlich, daß es an der Ankoppelstelle deswegen leicht Probleme geben kann, da Magazine 5 von verschiedenen Herstellern unterschiedliche Ausbildungen bzw. Querschnitte haben, was zu Problemen beim Ankoppeln an die Zuführschiene 2 führen kann. Dadurch entstehen aber undefinierte Verhältnisse bei der Bauteilezuführung zum Abholplatz, was zu Störungen im Fertigungsbetrieb führen kann.

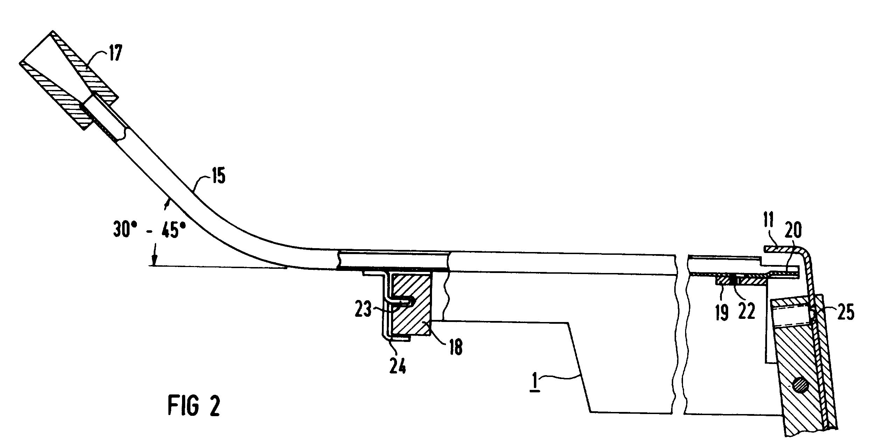

In FIG. 2 ist eine durchgehende Zuführschiene 15 vorhanden, die in ihrer Länge der Summe aus bisheriger Zuführschiene 2 und Stangenmagazin 5 entspricht. Diese durchgehende Zuführschiene 15 kann nachträglich mit Hilfe eines Fixierklotzes 18 und einem Lochblech 19 an den vorhandenen Linearförderer 1 angebaut werden. Die bisher verwendete Blechmuffe 4 und der diesbezügliche Lagerbock 6 werden dann nicht mehr benötigt.

Maschinenbedingt ist die neue Zuführschiene 15 zum besseren Durchrutschen der Bauteile aus dem hinteren Bereich auf eine Schräge von etwa 36° gegenüber der Horizontalen gebogen. An ihrem rückseitigen Ende weist die Zuführschiene 15 einen Trichter 17 auf, der zum Umfüllen der Bauteile aus dem angelieferten Stangenmagazin dient. Um das Rastermaß des vorhandenen Linearförderers 1 einzuhalten, können mehrere nebeneinander liegende Trichter 17, 17', 17'' aufgrund eines dafür verwendeten federnden Materials versetzt angeordnet werden.

Am vorderen Ende der Zuführschiene 15 ist ein Podest 20 vorhanden, das ein Verhaken von Bauteilen an seitlichem Grat od. dgl. verhindert. Für eine eindeutige Höhenlage und Stabilität ist nunmehr ein verstärkter Niederhalter 21 vorhanden, der mit einer Kugelraste 25 versehen ist. Dadurch lassen sich bei einer Bauteilumstellung mehrere Niederhalter 21 schnell und in definierter Höhenlage auswechseln. Die Zuführschiene 15 ist seitlich durch zwei herausgedrückte Nasen 22 und 23 fixiert und wird in der Höhe durch ein angepunktetes Halteblech 24 festgehalten.

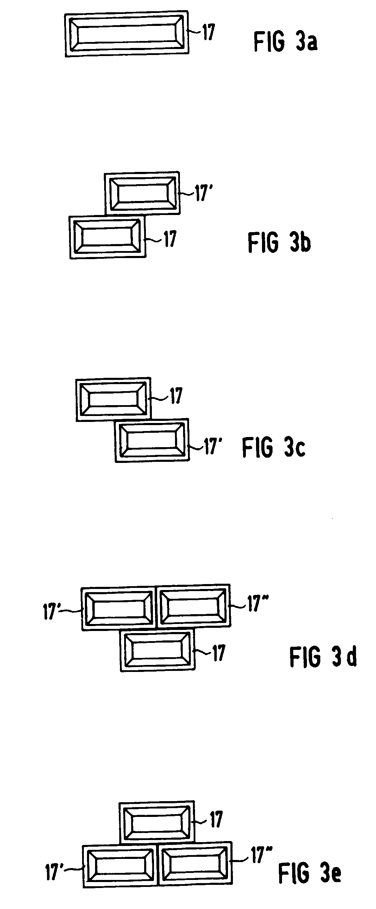

Es wurde erprobt, daß mehrere Zuführschienen 15 bzw. 15', 15'' vorteilhaft nebeneinander angeordnet werden können, was nicht im einzelnen dargestellt ist. Da die zugehörigen Trichter 17 bzw. 17', 17'' am Ende von diesbezüglichen Zuführschienen 15, 15', 15'' angeklebt sind, lassen sich die einzelnen Trichter, 17, 17', 17'' wegen der Elastizität der Zuführschienen gegeneinander versetzen. Letzteres ist für fünf unterschiedliche Konfigurationen anhand der FIG. 3a bis 3e dargestellt. Insbesondere ist dabei jeweils gemäß FIG. 2 der Fixierklotz 18 und das Lochblech 19 so ausgebildet, daß alternativ eine Dreier-, Zweier- oder Eineranordnung realisiert werden kann. Im einzelnen zeigt FIG. 3a eine Einer-Anordnung für besonders breite Bauteile, die FIG. 3b und 3c zeigen zwei unterschiedliche Zweier-Anordnungen und die FIG. 3d und 3e zwei unterschiedliche Dreier-Anordnungen. Im Einzelfall lassen sich die Konfigurationen entsprechend den vorgegebenen Randbedingungen beliebig verändern und an die jeweiligen Verhältnisse anpassen.

Es ist möglich, die bauteilabhängigen Abmessungen aller Zuführschienen tabellarisch zu erfassen und in die Logistik einer integrierten Fertigung einzubinden.

## Patentansprüche

1. Vorrichtung zum Zuführen von SMD-Bauteilen, insbesondere von Halbleiter-Chips, zu einem Bestückautomaten zum Bestücken von Leiterplatten mit den Bauteilen, mit mindestens einer auf einem Linearförderer angeordneten Zuführschiene in welcher die Bauteile zu einem Abholplatz transportiert werden, **dadurch gekennzeichnet,** daß die Zuführschiene (15) in ihrer Länge durchgehend über den gesamten Zuführbereich ausgebildet ist und nur in ihrem vorderen Bereich auf dem Linearförderer (1) aufsitzt und daß die Zuführschiene an ihrem rückseitigen Ende einen Trichter (17) zum Einfüllen der Bauteile aufweist.

2. Vorrichtung nach Anspruch 1, **dadurch gekennzeichnet,** daß die Zuführschiene (15) in dem vor dem Linearförderer (1) liegenden Bereich gegenüber der Horizontalen zwischen 30° und 45° abgekrümmt ist, vorzugsweise in einem Winkel von etwa 36°.

3. Vorrichtung nach Anspruch 1, **dadurch gekennzeichnet,** daß der Trichter (17) mit dem Ende der Zuführschiene (15) verklebt ist.

4. Vorrichtung nach Anspruch 3, **dadurch gekennzeichnet,** daß der Trichter (17) eine bauteilspezifische Beschriftung aufweist.

5. Vorrichtung nach Anspruch 1, **dadurch gekennzeichnet,** daß die Zuführschiene (15) vor dem Linearförderer (1) mittels eines Halterungselementes (23) in einem Fixierklotz (18) und zugehörigem Halteblech (24) fixiert ist.

6. Vorrichtung nach Anspruch 5, **dadurch gekennzeichnet,** daß als Mittel zur seitlichen Halterung der Zuführschiene (15) einzelne Fixiernasen (22,23) vorhanden sind.

7. Vorrichtung nach Anspruch 1, **dadurch gekennzeichnet,** daß die Zuführschiene (15) am Bestückautomaten einen beweglichen, steckbaren Niederhalter (21) für das jeweils letzte Bauteil aufweist.

8. Vorrichtung nach Anspruch 7, **dadurch gekennzeichnet,** daß der Niederhalter (21) mittels einer Kugelraste (25) beweglich austauschbar gelagert ist.

9. Vorrichtung nach Anspruch 8, **dadurch gekennzeichnet,** daß die Zuführschiene (15) an ihrem Ende ein erhöhtes Podest (20) bildet.

10. Vorrichtung nach Anspruch 1 oder einem der Ansprüche 2 bis 9, **dadurch gekennzeichnet,** daß mehrere Zuführschienen (15) nebeneinander ein Zuführsystem für unterschiedlich ausgebildete Bauelemente bilden.

11. Vorrichtung nach Anspruch 10, **dadurch gekennzeichnet,** daß bei mehreren parallelen Zuführschienen (15) die Einfülltrichter (17, 17', 17") jeweils versetzt übereinander bzw. nebeneinander angeordnet sind.

## Claims

1. Device for feeding SMD components, in particular semiconductor chips, to an automatic component mounting machine for populating printed circuit boards with the components, having at least one feed rail which is arranged on a linear conveyor and in which the components are transported to a pick-up point, characterized in that the feed rail (15) is designed such that its length is continuous over the entire feed range and is seated only in its front region on the linear conveyor (1), and in that the feed rail has at its rear end a funnel (17) for the insertion of the components.

2. Device according to Claim 1, characterized in that the feed rail (15) is curved between 30° and 45° with respect to the horizontal in the area located in front of the linear conveyor (1), preferably at an angle of about 36°.

3. Device according to Claim 1, characterized in that the funnel (17) is bonded to the end of the feed rail (15).

4. Device according to Claim 3, characterized in that the funnel (17) has a component-specific inscription.

5. Device according to Claim 1, characterized in that the feed rail (15) is fixed in front of the linear conveyor (1) by means of a holding element (23) in a fixing block (18) and an associated holding plate (24).

6. Device according to Claim 5, characterized in that individual fixing tabs (22, 23) are provided as means for holding the feed rail (15) laterally.

7. Device according to Claim 1, characterized in that the feed rail (15) on the automatic component mounting machine has a movable, plug-in hold-down device (21) for the respectively last component.

8. Device according to Claim 7, characterized in that the hold-down device (21) is mounted movably and replaceably by means of a ball catch (25).

9. Device according to Claim 8, characterized in that the feed rail (15) forms a raised pedestal (20) at its end.

10. Device according to Claim 1 or one of Claims 2 to 9, characterized in that a plurality of feed rails (15) side by side form a feed system for components of different design.

11. Device according to Claim 10, characterized in that, in the case of a plurality of parallel feed rails (15), the insertion funnels (17, 17', 17") are in each case arranged offset one above the other or side by side.

## Revendications

1. Dispositif pour envoyer des composants à monter en surface, notamment des puces à semi-conducteurs, à une machine automatique d'équipement, servant à équiper des plaquettes à circuits imprimés de composants, comportant au moins un rail d'amenée, qui est monté sur un convoyeur linéaire et dans lequel les composants peuvent être transportés à un emplacement de prélèvement, caractérisé en ce que le rail (15) d'amenée est, en sa longueur, formé continûment sur toute la région d'amenée et ne repose que dans sa région avant sur le convoyeur (1) linéaire, et par le fait que le rail d'amenée comporte à son extrémité arrière un entonnoir (17) servant à charger les composants.

2. Dispositif suivant la revendication 1, caractérisé en ce que le rail (15) d'amenée est coudé dans la région se trouvant en amont du convoyeur (1) linéaire, par rapport à l'horizontale, d'un angle compris entre 30° et 45°, de préférence d'un angle d'environ 36°.

3. Dispositif suivant la revendication 1, caractérisé en ce que l'entonnoir (17) est collé à l'extrémité du rail (15) d'amenée.

4. Dispositif suivant la revendication 3, caractérisé en ce que l'entonnoir (17) a un marquage spécifique à des composants.

5. Dispositif suivant la revendication 1, caractérisé en ce que le rail (15) d'amenée est immobilisé en amont du convoyeur (1) linéaire, au moyen d'un élément (23) de fixation, sur un billot (18) d'immobilisation et sur une tôle (24) de maintien associée.

6. Dispositif suivant la revendication 5, caractérisé en ce qu'il est présent comme moyens de fixation latéraux du rail (15) d'amenée des ergots (22, 23) individuels d'immobilisation.

7. Dispositif suivant la revendication 1, caractérisé en ce que le rail (15) d'amenée comporte pour le dernier composant, sur la machine automatique d'équipement, un serre-flan (21) mobile qui peut être emmanché.

8. Dispositif suivant la revendication 7, caractérisé en ce que le serre-flan (21) est, au moyen d'un loqueteau (25) à bille, monté mobile de manière à pouvoir être remplacé.

9. Dispositif suivant la revendication 8, caractérisé en ce que le rail (15) d'amenée comporte à son extrémité un plateau (20) surélevé.

10. Dispositif suivant la revendication 1 ou une des revendications 2 à 9, caractérisé en ce que plusieurs rails (15) d'amenée montés côte-à-côte forment un système d'amenée de composants de forme différente.

11. Dispositif suivant la revendication 10, caractérisé en ce que, pour plusieurs rails (15) d'amenée parallèles, les entonnoirs (17, 17', 17") d'entrée sont montés décalés les uns au-dessus des autres et/ou les uns à côté des autres.
